# EUROPÄISCHE PATENTSCHRIFT

(11) **EP 2 393 152 B1**
(45) Veröffentlichungstag und Bekanntmachung des Hinweises auf die Patenterteilung: **06.08.2014**
(21) Anmeldenummer: 11004515.0
(22) Anmeldetag: 01.06.2011
(51) Int. Cl.: H01M 10/46, H01M 10/052, G01R 31/36

(54) **Batteriesteuervorrichtung**
Battery control device
Dispositif de commande de batterie

(30) Priorität: 04.06.2010 DE 102010022792; 12.07.2010 DE 102010026829
(43) Veröffentlichungstag der Anmeldung: 07.12.2011
(73) Patentinhaber: STILL GmbH, 22113 Hamburg (DE)
(72) Erfinder: Claus, Alexander, 22303 Hamburg (DE); Tödter, Joachim, Dr., 22391 Hamburg (DE)
(74) Vertreter: Geirhos, Johann

(56) Entgegenhaltungen:
- WO-A2-2006/045016
- DE-A1- 2 630 033
- DE-A1-102005 038 648
- DE-A1-102006 051 586

## Beschreibung

Die Erfindung betrifft eine Batteriesteuervorrichtung nach dem Oberbegriff des Patentanspruchs 1.

Bei Fahrzeugen mit batterie-elektrischem Antrieb ist es insbesondere bei Flurförderzeugen, wie beispielsweise Gabelstaplern, üblich, als Traktionsbatterie zur Stromversorgung für einen Fahrantrieb und gegebenenfalls weiterer Verbraucher, wie einer Arbeitshydraulik, Wechselbatteriesysteme vorzusehen, um bei einer entladenen Batterie durch einen Tausch mit einer geladenen Batterie das Fahrzeug weiter einsetzen zu können. Zudem ist es möglich, eine entladene Batterie in einem Fahrzeug aufzuladen ohne die Batterie zu entnehmen.

Bei den Batterien handelt sich bisher zumeist um Bleibatterien, bei denen Tiefentladungen für das Erreichen einer langen Lebensdauer der Batterie vermieden werden sollten. Auch erfolgt der Wechsel bzw. das Laden einer Batterie zweckmäßigerweise an festgelegten Orten, wie etwa einer Ladestation, und das Fahrzeug sollte diese in jedem Fall noch erreichen können. Daher sind Batterieladezustandseinrichtungen bekannt, die in dem Fahrzeug z.B. in eine elektronische Fahrzeugsteuerung integriert sind und den Entladevorgang und somit den Ladezustand der Batterien überwachen, indem beispielsweise Entladeströme und die Spannung sowie die Batterietemperatur erfasst werden. Aus diesen Größen als Parameter kann der augenblickliche Ladezustand der Batterie bestimmt werden. Bei Bleibatterien erfasst eine übliche Batterieladezustandseinrichtung die Ruhespannung der Bleibatterie, wenn diese keine Leistung liefert und dieser kein oder ein nur sehr geringer Strom entnommen wird, und bestimmt aus einer Spannungskennlinie die relative Entladung und Entladetiefe der Bleibatterie. Übliche Ausführungen solcher Bleibatterien, die etwa als Traktionsbatterien in Flurförderzeugen eingesetzt werden, sind Kupferstreckmetallbatterien (CSM) oder Röhrchenplattenbatterien. Häufig dient die Batterieladezustandseinrichtung dazu, einer Bedienperson den Ladezustand bzw. die Entladetiefe über eine Anzeigevorrichtung anzuzeigen.

Die Batterieladezustandsüberwachung erfolgt bei Bleibatterien nicht durch eine mit der Batterie verbundene Vorrichtung, sondern ist in das Fahrzeug integriert, in dem die Batterie eingesetzt wird. Dabei kann die Batterieladezustandseinrichtung beispielsweise in eine digitale Fahrzeugsteuerung integriert sein und rein über Software unter Verwendung von zur Verfügung stehenden Parametern erfolgen, insbesondere der Ruhespannung der Batterie. Alternativ sind auch Ausführungen bekannt, bei denen eine eigene Vorrichtung für die Batterieladezustandseinrichtung in dem Fahrzeug vorgesehen ist und diese eigene Sensoren, etwa Spannungssensoren, zur Messung der Batteriespannung aufweist.

Bei anderen Batterietypen als Bleibatterien ergeben sich z.T. deutlich größere Batteriekapazitäten und auch weitere Vorteile im Betrieb. Einen solchen anderen Batterietyp stellen Li-lonen-Batterien dar. Bei Li-lonen-Batterien wird der Ladezustand in der Batterie ermittelt, genauer in einem Batteriemanagementsystem (BMS), das in jedem Fall erforderlich ist, um den sicheren Betrieb der Li-lonen-Batterie zu gewährleisten.

Nachteilig an diesem Stand der Technik ist, dass die Batterieladezustandseinrichtung im Fahrzeug, etwa eine, die aus der Ruhespannung einer Bleibatterie den Ladezustand bestimmt, für andere Batterietypen, insbesondere Li-lonen-Batterien, keine sinnvollen Ergebnisse liefert, weil bei Li-lonen-Batterien über weite Bereiche der Entladung eine nahezu konstante Ruhespannung vorliegt, die sich von den für Bleibatterien ausgelegten Batterieladezustandseinrichtungen nicht auflösen lässt bzw. bei diesen durch andere Effekte überdeckt wird.

Es ist daher denkbar, bei einem Fahrzeug, das mit einer Li-lonen Batterie ausgerüstet werden soll, die Batterieladezustandseinrichtung auszutauschen.

Dies ist jedoch kostenaufwändig und erfordert bei einer Vielzahl von verschiedenen Fahrzeugtypen jedes Mal eigenen konstruktiven Aufwand für die individuelle Anpassung. Für den Fall, dass bestehende Fahrzeuge nachträglich mit Li-lonen-Batterien oder ganz allgemein mit neuen Batterietypen ausgerüstet werden sollen, ist eine solche Ausstattung mit geeigneten Batterieladezustandseinrichtungen aufgrund der großen Anzahl von Fahrzeugtypen noch schwerer umzusetzen.

Es ist weiter denkbar, eine weitere Schnittstelle mit Datenübertragungsleitung vorzusehen, mit der ein Wert für die ermittelte Entladetiefe an das Fahrzeug übergeben werden kann.

Nachteilig an diesem Stand der Technik ist, dass die dazu notwendige Schnittstelle zwischen Batteriemanagementsystem und Fahrzeug zuverlässig, robust und mit geringem Aufwand umsetzbar sein muss. Dies ist jedoch schwierig zu erreichen.

Aus der DE 10 2005 038 648 A1 ist ein Flurförderzeug mit mindestens einer Batterie und Mitteln zur Ermittlung und/oder Anzeige von Kenngrößen für die verfügbare elektrische Energie bekannt. Die Bestimmung einer Kenngröße für die verfügbare elektrische Energie kann ausschließlich aus dem zeitlichen Verlauf der an der Batterie anliegenden Spannung erfolgen.

Aus der DE 26 30 033 A1 ist eine Einrichtung zum Messen des Entladezustandes einer elektrischen Batterie, an die mindestens ein Verbraucher von elektrischem Strom, vorzugsweise ein Elektromotor, anschließbar ist, bekannt, bei der die Batteriespannung nur in Schaltzuständen, in denen kein Verbraucher der Batterie Strom entnimmt, gemessen wird und aus dieser Batteriespannung der Ladezustand der Batterie bestimmt wird.

Aus der WO 2006/045016 A2 ist ein Lithiumbatteriesystem bekannt, bei dem die Ausgangsspannung der Lithiumbatterie in eine Ausgangsspannung entsprechend einer Bleibatterie umgesetzt wird, um das Batteriesystem anstelle einer Bleibatterie in einem Fahrzeug einzusetzen. Dabei wird die gesamte Ausgangsleistung der Lithiumsbatterie umgesetzt.

Der vorliegenden Erfindung liegt die Aufgabe zugrunde, eine Batteriesteuervorrichtung, eine Batterie sowie ein zugehöriges Flurförderzeug zur Verfügung zu stellen, um mit möglichst geringen Modifikationen an dem Li-lonen-Batterien einsetzen zu können.

Diese Aufgabe wird durch eine Batteriesteuervorrichtung mit den Merkmalen des Anspruchs 1, eine Batterie mit den Merkmalen des Anspruchs 6, ein Fahrzeug mit den Merkmalen des Anspruchs 10 sowie durch ein System mit den Merkmalen des Anspruchs 13 gelöst. Vorteilhafte Weiterbildungen sind in den Unteransprüchen angegeben.

Die Aufgabe wird durch eine Batteriesteuervorrichtung einer Li-lonen-Batterie einer mobilen Arbeitsmaschine oder eines Flurförderzeugs, wobei die Li-Ionen-Batterie als Traktionsbatterie in ein Batteriefach der mobilen Arbeitsmaschine oder des Flurförderzeugs einsetzbar sowie auswechselbar ist, gelöst. Die mobile Arbeitsmaschine oder das Flurförderzeug weist eine Batterieladezustandseinrichtung auf, die für eine Bleibatterie, anhand von mindestens einem Parameter, wie etwa Ruhespannung und/oder Belastungsspannung und/oder Strom, den Ladezustand bestimmen kann. Die Batteriesteuervorrichtung kann den Ladezustand der Li-lonen-Batterie erfassen und in mindestens einen dem Ladezustand entsprechenden Parameter für die Bleibatterie umsetzen und diesen umgesetzten Parameter über ein Verbindungsmittel an die Batterieladezustandseinrichtung übertragen, so dass durch die Batterieladezustandseinrichtung der mobilen Arbeitsmaschine oder des Flurförderzeugs der Ladezustand der Li-lonen-Batterie erfasst werden kann. Vorteilhaft dient als Verbindungsmittel zu der mobilen Arbeitsmaschine oder dem Flurförderzeug eine drahtlose Funkverbindung und/oder eine Verbindungsleitung.

Dadurch wird es für ein Fahrzeug, etwa als Beispiel ein Gabelstapler als Flurförderzeug, das für eine übliche Bleibatterie hinsichtlich der Batterieladezustandseinrichtung ausgelegt ist, auf einfache Weise und mit geringem Bauaufwand möglich, eine Li-lonen-Batterie einzusetzen, da die Parameter für die Bleibatterie in der Batteriesteuervorrichtung simuliert werden und daher die Batterieladezustandseinrichtung den richtigen Ladezustand, beispielsweise einen prozentualen Wert, der Batterie berechnet und anzeigt. Durch eine drahtlose Funkverbindung werden zusätzlich Kabel und mögliche Fehlerquellen vermieden, wenn etwa bei einem Batteriewechsel ein zusätzliches Kabel nicht angeschlossen wird. Eventuell muss die per Funk übertragene Information in dem Fahrzeug in eine Spannung umgesetzt werden und die Spannung den Signalleitungen oder Spannungssensoren der Batterieladezustandseinrichtung zugeführt werden.

Vorteilhaft kann die Batteriesteuervorrichtung den Ladezustand der Li-Ionen-Batterie aus mindestens einem Ladungsparameter der der Li-lonen-Batterie erfassen, wie etwa Entladestrom und/oder Entladespannung.

In vorteilhafter Ausgestaltung entspricht ein entsprechender Parameter einer Ruhespannung einer Bleibatterie.

Die Messung und Auswertung der Ruhespannung einer Bleibatterie, wenn dieser keine oder nur eine verschwindend geringe Leistung entnommen wird, ist eine mit einer relativ einfach aufgebauten Batterieladezustandseinrichtung umsetzbare Möglichkeit der Erfassung des Ladezustands. Eine solche Batterieladezustandseinrichtung ist auch in vielen Fahrzeugen, insbesondere Flurförderzeugen, schon seit Jahren eingebaut. Vor allem für einen nachträglichen Einsatz neuerer Batterietypen kann daher über die Simulation der Ruhespannung einer Bleibatterie eine Erfassung des Ladezustands erfolgen.

In einer günstigen Ausführungsform der Erfindung entspricht ein entsprechender Parameter für die Bleibatterie einer Kennlinie einer Ruhespannung mit niedrigen Spannungswerten entsprechend einem virtuellen, nicht realen Akkumulator als Bleibatterie.

Wenn das Fahrzeug in Form einer mobilen Arbeitsmaschine oder eines Flurförderzeugs, bei dem die Batteriesteuervorrichtung mit einer Batterie zum Einsatz kommt, eine Steuerung aufweist, in der mehrere Kennlinien für Ruhespannungen abgespeichert werden können, insbesondere das Fahrzeug eine durch Software programmierbare Steuerung aufweist, so kann eine eigene Kennlinie mit sehr niedrigen Spannungswerten abgespeichert werden. Dann muss das Signal der Batteriesteuervorrichtung, das diese über die Verbindungsleitung an die Batterieladezustandseinrichtung abgibt, nicht über Spannungssensoren erfasst werden, sondern kann direkt der Schaltung über Analog-Digitalwandler zugeleitet werden. Diese weitere Kennlinie für die Ruhespannung ist völlig unabhängig von der Batteriespannung der Bleibatterie und entspricht daher nur einem virtuellen Akkumulator. Es können geringere Spannungen als die z.B. bei Flurförderzeugen üblichen Batterienennspannungen von 24 V, 48 V, 80V oder 96 V verwendet werden. Diese kleineren Spannungen, z.B. im Bereich von 0 Volt bis 5 Volt, lassen sich in einem Digital-Analogwandler der Batteriesteuervorrichtung auch einfacher erzeugen.

Vorteilhaft entspricht ein entsprechender Parameter für die Bleibatterie einem lastabhängigen Spannungseinbruch.

Damit wird zusätzlich das Verhalten einer Bleibatterie genauer simulieren.

Statt auf der Batteriesteuervorrichtung können Spannungen als Parameter auch auf einer getrennten, abgesetzten Einheit erzeugt werden.

Die Aufgabe wird auch durch eine Batterie, die als der Li-lonen-Batterie ausgeführt ist, mit einer zuvor beschriebenen Batteriesteuervorrichtung gelöst.

Wenn die Batteriesteuervorrichtung der Batterie zugeordnet wird und zusammen mit der Batterie eingesetzt wird, wenn auch eventuell als getrenntes Bauteil, so wird der Zusatzaufwand bei dem Fahrzeug vermieden oder zumindest gering gehalten. Auch ist eine individuelle Anpassung an die Batterie möglich und wird die Gefahr einer falschen Zuordnung vermieden. Auch wird die Anzahl an Varianten der Fahrzeuge gering gehalten. Dennoch können unterschiedliche Fahrzeuge mit minimalen Anpassungen sowohl Bleibatterien aufnehmen als auch Li-lonen-Batterien. Dies ermöglicht eine zügige Einführung von Li-lonen-Batterien über eine Vielzahl von unterschiedlichen Fahrzeugen, etwa Flurförderzeugen. Li-Ionen-Batterien stellen für den Einsatz in Fahrzeugen aufgrund der hohen Energiedichte einen besonders vorteilhaften Batterietyp dar. Damit lassen sich Li-lonen-Batterien auch in Fahrzeugen einsetzen, die keine anpassbaren Batterieladeanzeiger bzw. externe Schnittstellen zur Übermittlung besitzen.

Vorteilhaft ist die Batteriesteuervorrichtung in eine Batteriemanagementvorrichtung der Batterie integriert.

Li-lonen-Batterien benötigen eine Batteriemanagementvorrichtung, die den Ladezustand erfasst. Eine Integration der Batteriesteuervorrichtung ist daher kostengünstig und relative einfach zu erreichen.

Die Batteriesteuervorrichtung kann an einem Anschlusskabel der Batterie angeordnet sein.

Die Batteriesteuervorrichtung kann dabei elektrisch untrennbar mit der Batterie verbunden sein.

Als Verbindungsleitung zu dem Fahrzeug können ein zusätzlicher Stecker und/oder die Hilfskontakte eines Anschlusskabels der Batterie und/oder die Pilotkontakte eines Anschlusskabels der Batterie dienen.

Die Aufgabe wird auch durch ein Fahrzeug, ausgeführt als eine mobile Arbeitsmaschine oder ein Flurförderzeug, gelöst, das batterie-elektrisch angetrieben wird, mit einer Batterie die als Traktionsbatterie in ein Batteriefach einsetzbar ist. Das Fahrzeug weist eine Batterieladezustandseinrichtung auf, die für eine Bleibatterie, anhand von Kennlinien oder Kennfeldern von Parametern den Ladezustand bestimmen kann. Als Batterie kann eine zuvor beschriebene Batterie als Li-lonen-Batterie in das Fahrzeug eingesetzt werden und es sind entsprechende Anschluss- oder Empfangsmöglichkeiten für die Verbindungsmittel vorgesehen. Das Fahrzeug ist daher auf einfache Weise alternativ mit einer Bleibatterie, oder einer Li-lonen-Batterie, ausrüstbar und mit diesen betreibbar, ohne dass es zu Fehlerfassungen des Ladezustands kommt.

Die Batterieladezustandseinrichtung, die in eine Fahrzeugsteuerung integriert sein kann, kann dabei die bereits vorhandenen Sensoren einsetzen, die dann im Fall von Spannungssensoren etwa von der Batteriespannung zu trennen und mit der von der Batteriesteuervorrichtung generierten Spannung als Beispiel des Parameters zu verbinden sind.

Besonders vorteilhaft kann die erfindungsgemäße Lösung bei Fahrzeugen eingesetzt werden, die für Steuerungsaufgaben, wie etwa die Überwachung des Ladezustands der Batterie, kein Bussystem, wie etwa einen CAN-Bus, einsetzen. Solche Fahrzeuge weisen zum Teil nur sehr einfache Ladungsüberwachungsanzeigen, wie etwa einen mit entsprechender Skala versehenen Spannungsmesser auf. Vor allem für diesen Fall bietet die erfindungsgemäße Lösung einen kostengünstigen und mit verhältnismäßig geringem Aufwand umzusetzenden Lösungsweg, eine Li-lonen-Batterie einzusetzen.

In vorteilhafter Ausführungsform ist in der Batterieladezustandseinrichtung des Fahrzeugs eine Kennlinie einer Ruhespannung mit niedrigen Spannungswerten entsprechend einem virtuellen, nicht realen Akkumulator hinterlegt.

Dies ermöglicht die Übertragung von Spannungswerten für eine virtuelle Bleibatterie und es entfällt das Erfordernis hohe Spannungen zu erzeugen. Auch können diese Signale eventuell direkt einem Analog-Digitalwandler ohne Spannungssensor zugeführt werden. Eine solche Kennlinie eines virtuellen Akkumulators lässt sich besonders leicht bei per Software programmierbaren Batterieladezustandseinrichtungen umsetzen, etwa, wenn diese in eine controllergesteuerte Fahrzeugsteuerung integriert ist. Auch ermöglicht dies eine weitere Aufspreizung der Werte, so dass die Entladung nicht durch einen Wertebereich von z.B. 4,5 Volt bis 4,0 Volt, sondern in einem "aufgespreizten" Bereich von 4,5 Volt bis 0,5 Volt bestimmt wird.

In vorteilhafter Ausgestaltung der Erfindung sind die Verbindungsmittel als Verbindungsleitung ausgebildet und können zusätzliche Spannungssensoren an der Verbindungsleitung anliegende Spannungen erfassen und der Batterieladezustandseinrichtung des Fahrzeugs zuleiten.

Die Aufgabe wird auch durch ein System aus mindestens einem zuvor beschriebenen Fahrzeug, mindestens einer Bleibatterie, und mindestens einer zuvor beschriebenen Batterie als Li-lonen-Batterie, gelöst.

Dadurch ist in einem Fahrzeug und in einer Fahrzeugflotte der freizügige Einsatz von unterschiedlichen Batterietypen möglich. Dabei wird stets der Ladezustand des jeweils eingesetzten Batterietyps durch die Batterieladezustandseinrichtung des Fahrzeugs korrekt erfasst.

Weitere Vorteile und Einzelheiten der Erfindung werden anhand der in den schematischen Figuren dargestellten Ausführungsbeispiele näher erläutert. Hierbei zeigt
- Fig. 1: eine schematische Ansicht eines erfindungsgemäßen Flurförderzeugs mit einer eingesetzten erfindungsgemäßen Batterie,
- Fig. 2: eine Parameterkennlinie der Ruhespannung einer Bleibatterie und
- Fig. 3: eine schematische Ansicht eines erfindungsgemäßen Systems.

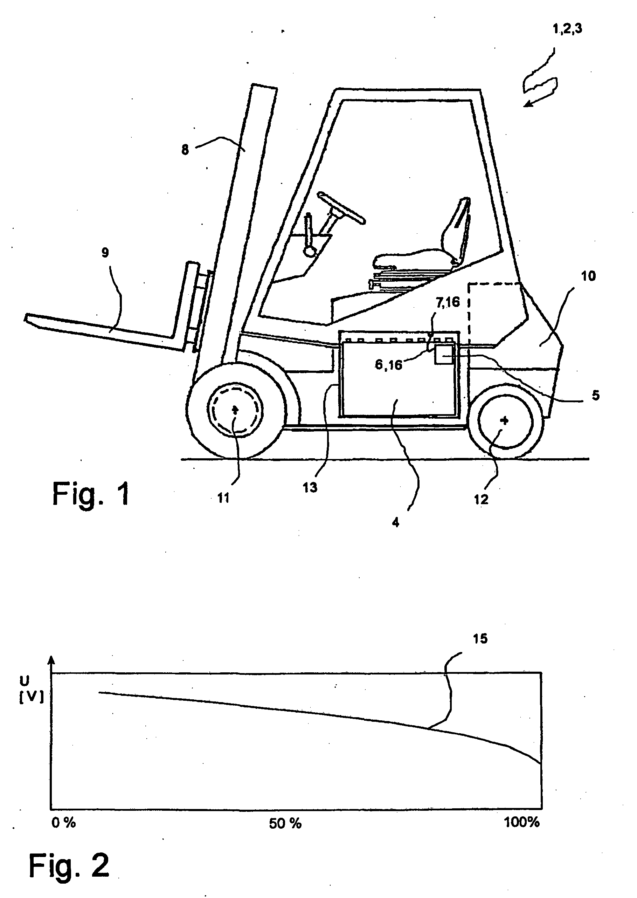

Die Fig. 1 zeigt eine schematische Ansicht eines Fahrzeugs 1 in einem Ausführungsbeispiel als erfindungsgemäßes Flurförderzeug 2, hier in Form eines Gabelstaplers 3 mit einer in ein Batteriefach 13 eingesetzten erfindungsgemäßen Batterie 4. Die Batterie 4 ist eine Li-lonen-Batterie 4 und weist eine an der Batterie 4 angeordnete Batteriesteuervorrichtung 5 auf, die über eine Verbindungsleitung 6 und einen zusätzlichen Stecker 7 mit dem Gabelstapler 3 verbunden ist. Der zusätzliche Stecker 7 und die Verbindungsleitung 6 bilden ein Verbindungsmittel 16. Der Gabelstapler 3 weist einen Hubmast 8 mit einer Lastgabel 9 sowie einem Gegengewicht 10 auf. Zwischen einer Vorderachse 11 und einer Hinterachse 12 ist die Li-Ionen-Batterie 4 in das Batteriefach 13 eingesetzt. Mit der der Li-Ionen-Batterie 4 entnommenen elektrischen Leistung werden ein nicht dargestellter Fahrantrieb sowie die weiteren Funktionen des Gabelstaplers 3 angetrieben, etwa eine Arbeitshydraulik des Hubmastes 8.

Der Gabelstapler 3 weist eine nicht näher dargestellte Batterieladezustandseinrichtung auf, durch die der Ladezustand bzw. die Entladetiefe für eine Bleibatterie ermittelt und/oder angezeigt werden kann. Dabei wird die Ruhespannung einer als Batterie eingesetzten Bleibatterie bestimmt, die im Fall keiner oder nur einer verschwindend geringen Leistungsentnahme aus der Bleibatterie an den Anschlüssen der Bleibatterie anliegt.

Der erfindungsgemäße Gabelstapler 3 ist dafür vorgesehen, dass anstatt der Bleibatterie eine Li-lonen-Batterie mit einer erfindungsgemäßen Batteriesteuervorrichtung 5 in das Batteriefach 13 eingesetzt wird. Wenn der Stecker 7 mit der Verbindungsleitung 6 angeschlossen ist, wird die Verbindung der Batterieladezustandseinrichtung des Gabelstaplers 3 mit Spannungssensoren zur Messung der Batteriespannung unterbrochen und stattdessen wird der Batterieladezustandseinrichtung eine von der Batteriesteuervorrichtung erzeugte virtuelle Batteriespannung als Parameter zugeleitet, die dem Ladezustand der Li-Ionen-Batterie 4 entspräche, wenn diese ein Bleibatterie wäre.

Somit wird an dieser Schnittstelle des Verbindungsmittels 16 eine Spannung übergeben, die die Batteriesteuervorrichtung 5 anhand des ermittelten Ladezustand des Li-lonen-Batterie generiert, wobei die Batteriesteuervorrichtung 5 die in ein Batteriemanagementsystem oder eine Batteriemanagementvorrichtung des Li-lonen-Batterie integriert sein kann. Die Spannung wird auf Kontakte in dem Stecker 7 ausgegeben und in dem Gabelstapler 3 abgegriffen und der Batteriesteuervorrichtung zugeleitet. Alternativ kann auch die Spannung fahrzeugseitigen Spannungssensoren zur Messung der Batteriespannung zugeleitet werden. Die Batteriesteuervorrichtung bzw. eine Fahrzeugsteuerung, soweit die Batteriesteuervorrichtung in die Fahrzeugsteuerung integriert ist, ermittelt aus der Spannung die Entladetiefe.

In dieser Ausführungsform wird als Parameter von der Batteriesteuervorrichtung 5 eine Spannung in Form der Ruhespannung einer Bleibatterie abgebildet. Im Ergebnis wird von der Batteriesteuervorrichtung 5 der Ladezustand der Li-lonen-Batterie in Relation zum Ruhespannungsverlauf einer entsprechenden Bleibatterie gesetzt.

Die Fig. 2 zeigt eine Parameterkennlinie 15 der Ruhespannung einer Bleibatterie. In der Hochachse ist eine Ruhespannung einer Bleibatterie in Volt über einem Entladungsgrad in Prozent als Rechtswert aufgetragen.

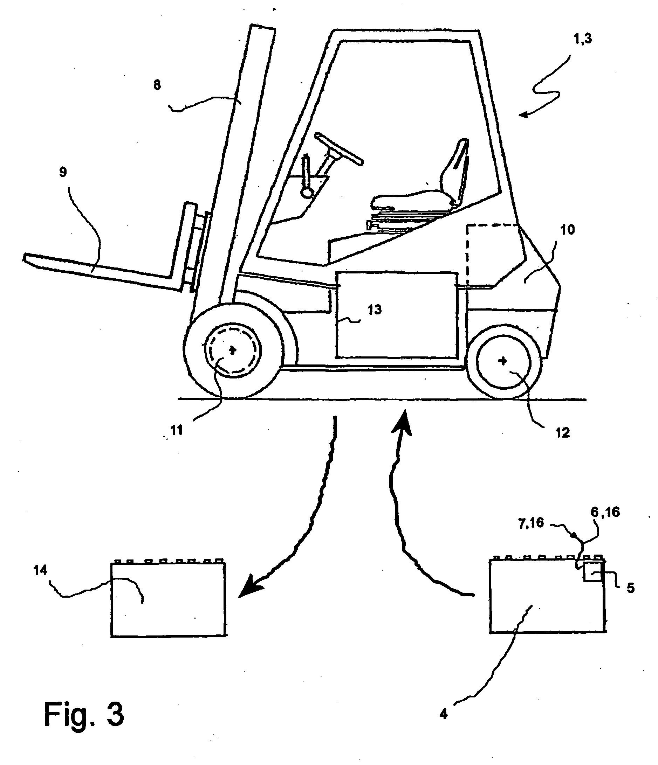

Die Fig. 3 zeigt eine schematische Ansicht eines erfindungsgemäßen Systems mit einem erfindungsgemäßen Fahrzeug 1 in einem Ausführungsbeispiel als Gabelstapler 3 entsprechend demjenigen der Fig. 1. Der Gabelstapler 3 weist den Hubmast 8 mit der Lastgabel 9 sowie dem Gegengewicht 10 auf. Zwischen der Vorderachse 11 und der Hinterachse 12 ist das Batteriefach 13 angeordnet. Zu dem System gehören eine Bleibatterie 14 sowie die Li-lonen-Batterie 4. Die Li-lonen-Batterie 4 ist mit der erfindungsgemäßen Batteriesteuervorrichtung 5 versehen, die die Verbindungsleitung 6 und den zusätzlichen Stecker 7 als Verbindungsmittel 16 aufweist.

Bei dem System kann nun die Bleibatterie 14 völlig frei durch die Li-lonen-Batterie 4 ersetzt werden, wie durch die Pfeile angedeutet. Dies ermöglicht es innerhalb einer Fahrzeugflotte gezielt Li-lonen-Batterien 4 einzusetzen, wo dies Vorteile bringt und gleichzeitig daneben in denselben Fahrzeugen auch Bleibatterien 14. Durch die Erfindung ist auch eine Nachrüstung mit Li-lonen-Batterien 4 für ältere Fahrzeuge leicht möglich.

Dabei ist die Batterieladezustandseinrichtung des Fahrzeugs 1 unverändert und es sind nur geringe Anpassungen des Fahrzeugs 1 erforderlich, um, wie zuvor mit Bezug auf Fig. 1 beschrieben, über die Verbindungsleitung 6 und den Stecker 7 als Verbindungsmittel 16 eine der Ruhespannung einer Bleibatterie entsprechenden Spannung der Batteriesteuervorrichtung des Fahrzeugs 1 zuzuleiten. Die Ruhespannung wird von der Batteriesteuervorrichtung 5 erzeugt und entspricht dem Ladezustand der Li-lonen-Batterie.

## Patentansprüche

1. Batteriesteuervorrichtung einer Li-lonen-Batterie einer mobilen Arbeitsmaschine oder eines Flurförderzeugs, wobei die Li-lonen-Batterie, als Traktionsbatterie in ein Batteriefach (13) der mobilen Arbeitsmaschine oder des Flurförderzeugs einsetzbar sowie auswechselbar ist, wobei die mobile Arbeitsmaschine oder das Flurförderzeug eine Batterieladezustandseinrichtung aufweist, die für eine Bleibatterie, anhand von mindestens einem Parameter, insbesondere Ruhespannung (15) und/oder Belastungsspannung und/oder Strom, den Ladezustand bestimmen kann,
**dadurch gekennzeichnet,**
**dass** die Batteriesteuervorrichtung (5) den Ladezustand der Li-lonen-Batterie erfassen kann und in mindestens einen dem Ladezustand entsprechenden Parameter für die Bleibatterie umsetzt und diesen umgesetzten Parameter über ein Verbindungsmittel (16) an die Batterieladezustandseinrichtung übertragen kann, so dass durch die Batterieladezustandseinrichtung der mobilen Arbeitsmaschine oder des Flurförderzeugs der Ladezustand der Li-lonen-Batterie erfasst werden kann, wobei das Verbindungsmittel (16) zu der mobilen Arbeitsmaschine oder dem Flurförderzeug eine drahtlose Funkverbindung ist und/oder als Verbindungsleitung (6) ausgebildet ist.

2. Batteriesteuervorrichtung nach Anspruch 1,
**dadurch gekennzeichnet,**
**dass** die Batteriesteuervorrichtung (5) den Ladezustand der Li-lonen-Batterie aus mindestens einem Ladungsparameter der Batterie (4) der Li-lonen-Batterie erfassen kann, wie etwa Entladestrom und/oder Entladespannung.

3. Batteriesteuervorrichtung nach Anspruch 1 oder 2,
**dadurch gekennzeichnet,**
**dass** ein entsprechender Parameter einer Ruhespannung (15) der Bleibatterie entspricht.

4. Batteriesteuervorrichtung nach einem der Ansprüche 1 bis 3,
**dadurch gekennzeichnet,**
**dass** ein entsprechender Parameter der Bleibatterie einer Kennlinie einer Ruhespannung mit niedrigen Spannungswerten entsprechend einer virtuellen, nicht realen Batterie als Bleibatterie, entspricht.

5. Batteriesteuervorrichtung nach einem der Ansprüche 1 bis 4,
**dadurch gekennzeichnet,**
**dass** ein entsprechender Parameter der Bleibatterie einem lastabhängigen Spannungseinbruch entspricht.

6. Batterie, die als der Li-lonen-Batterie ausgeführt ist, mit einer Batteriesteuervorrichtung (5) nach einem der Ansprüche 1 bis 5.

7. Batterie nach Anspruch 6,
**dadurch gekennzeichnet,**
**dass** die Batteriesteuervorrichtung (5) in eine Batteriemanagementvorrichtung der Batterie integriert ist.

8. Batterie nach Anspruch 6 oder 7,
**dadurch gekennzeichnet,**
**dass** die Batteriesteuervorrichtung an einem Anschlusskabel der Batterie angeordnet ist.

9. Batterie nach einem der Ansprüche 6 bis 8,
**dadurch gekennzeichnet,**
**dass** als Verbindungsleitung (6) zu dem Fahrzeug ein zusätzlicher Stecker (7) und/oder die Hilfskontakte eines Anschlusskabels der Batterie und/oder die Pilotkontakte eines Anschlusskabels der Batterie dienen.

10. Fahrzeug, ausgeführt als mobile Arbeitsmaschine oder Flurförderzeug, das batterie-elektrisch angetrieben wird, mit einer Batterie (4), die als Traktionsbatterie in ein Batteriefach (13) einsetzbar ist, wobei das Fahrzeug (1) eine Batterieladezustandseinrichtung aufweist, die für eine Bleibatterie anhand von Kennlinien oder Kennfeldern von mindestens einem Parameter den Ladezustand bestimmen kann, wobei als Batterie (4) eine Batterie nach einem der Ansprüche 6 bis 10 eingesetzt werden kann und entsprechende Anschluss- oder Empfangsmöglichkeiten für das Verbindungsmittel (16) vorgesehen sind.

11. Fahrzeug nach Anspruch 10,
**dadurch gekennzeichnet,**
**dass** in das Fahrzeug eine Batterie mit einer Batteriesteuervorrichtung nach Anspruch 3 einsetzbar ist und in der Batterieladezustandseinrichtung des Fahrzeugs eine Kennlinie einer Ruhespannung mit niedrigen Spannungswerten entsprechend einer virtuellen, nicht realen Batterie hinterlegt ist.

12. Fahrzeug nach Anspruch 10 oder 11,
**dadurch gekennzeichnet,**
**dass** die Verbindungsmittel (16) als Verbindungsleitung (6) ausgebildet sind und zusätzliche Spannungssensoren an der Verbindungsleitung (6) anliegende Spannungen erfassen und der Batterieladezustandseinrichtung des Fahrzeugs zuleiten können.

13. System aus mindestens einem Fahrzeug (1) nach einem der Ansprüche 10 bis 12, mindestens einer Bleibatterie, und mindestens einer Batterie (4) ausgeführt als Li-Ionen-Batterie, nach einem der Ansprüche 6 bis 9.

## Claims

1. Battery control apparatus of a lithium-ion battery of a mobile working machine or of an industrial truck, wherein the lithium-ion battery, as a traction battery, can be inserted into a battery compartment (13) of the mobile working machine or of the industrial truck and also can be replaced, wherein the mobile working machine or the industrial truck has a battery state of charge device which can determine the state of charge for a lead-acid battery on the basis of at least one parameter, in particular the open-circuit voltage (15) and/or load voltage and/or current,
**characterized**
**in that** the battery control apparatus (5) can detect the state of charge of the lithium-ion battery and convert it into at least one parameter for the lead-acid battery, which parameter corresponds to the state of charge, and can transmit this converted parameter to the battery state of charge device via a connecting means (16), so that the state of charge of the lithium-ion battery can be detected by the battery state of charge device of the mobile working machine or of the industrial truck, wherein the connecting means (16) to the mobile working machine or to the industrial truck is a wireless radio connection and/or is in the form of a connecting line (6).

2. Battery control apparatus according to Claim 1,
**characterized**
**in that** the battery control apparatus (5) can detect the state of charge of the lithium-ion battery from at least one charging parameter of the battery (4) of the lithium-ion battery, such as the discharge current and/or discharge voltage for example.

3. Battery control apparatus according to Claim 1 or 2,
**characterized**
**in that** a corresponding parameter corresponds to an open-circuit voltage (15) of the lead-acid battery.

4. Battery control apparatus according to one of Claims 1 to 3,
**characterized**
**in that** a corresponding parameter of the lead-acid battery corresponds to a characteristic curve of an open-circuit voltage with low voltage values corresponding to a virtual, imaginary battery as the lead-acid battery.

5. Battery control apparatus according to one of Claims 1 to 4,
**characterized**
**in that** a corresponding parameter of the lead-acid battery corresponds to a load-dependent voltage drop.

6. Battery which is designed as the lithium-ion battery, having a battery control apparatus (5) according to one of Claims 1 to 5.

7. Battery according to Claim 6,
**characterized**
**in that** the battery control apparatus (5) is integrated into a battery management apparatus of the battery.

8. Battery according to Claim 6 or 7,
**characterized**
**in that** the battery control apparatus is arranged on a connection cable of the battery.

9. Battery according to one of Claims 6 to 8,
**characterized**
**in that** an additional plug (7) and/or the auxiliary contacts of a connection cable of the battery and/or the pilot contacts of a connection cable of the battery serve as the connecting line (6) to the vehicle.

10. Vehicle, which is designed as a mobile working machine or industrial truck, which vehicle is driven electrically by battery, having a battery (4) which, as a traction battery, can be inserted into a battery compartment (13), wherein the vehicle (1) has a battery state of charge device which can determine the state of charge for a lead-acid battery on the basis of characteristic curves or characteristic maps of at least one parameter, wherein a battery according to one of Claims 6 to 10 can be used as the battery (4) and corresponding connection or receiving options are provided for the connecting means (16).

11. Vehicle according to Claim 10,
**characterized**
**in that** a battery having a battery control apparatus according to Claim 3 can be inserted into the vehicle, and a characteristic curve of an open-circuit voltage with low voltage values corresponding to a virtual, imaginary battery is stored in the battery state of charge device of the vehicle.

12. Vehicle according to Claim 10 or 11,
**characterized**
**in that** the connecting means (16) are in the form of a connecting line (6), and additional voltage sensors can detect voltages which are applied to the connecting line (6) and feed the said voltages to the battery state of charge device of the vehicle.

13. System comprising at least one vehicle (1) according to one of Claims 10 to 12, at least one lead-acid battery, and at least one battery (4), which is designed as a lithium-ion battery, according to one of Claims 6 to 9.

## Revendications

1. Dispositif de commande de batterie pour batterie à ions Li d'une machine de travail mobile ou d'un chariot de manutention,
la batterie à ions Li pouvant être utilisée comme batterie de traction dans un compartiment (13) de batterie de la machine mobile de travail ou du chariot de manutention et pouvant être remplacée,
la machine mobile de travail ou le chariot de manutention présentant un dispositif d'état de charge de batterie qui peut déterminer l'état de charge d'une batterie au plomb à l'aide d'au moins un paramètre et en particulier de la tension au repos (15) et/ou de la tension de charge et/ou du courant,
**caractérisé en ce que**
le dispositif (5) de commande de batterie peut déterminer l'état de charge de la batterie à ions Li et le convertir en au moins un paramètre correspondant à l'état de charge de la batterie au plomb et peut transmettre ce paramètre converti au dispositif d'état de charge de la batterie par l'intermédiaire d'un moyen de liaison (16) de telle sorte que l'état de charge de la batterie à ions Li puisse être saisi par le dispositif d'état de charge de la batterie de la machine de travail mobile ou du chariot de manutention,
le moyen de liaison (16) étant une liaison radio sans fil avec la machine mobile de travail ou le chariot de manutention et/ou étant configuré comme conducteur de liaison (6).

2. Dispositif de commande de batterie selon la revendication 1, **caractérisé en ce que** le dispositif (5) de commande de batterie peut détecter l'état de charge de la batterie à ions Li à partir d'au moins un paramètre de charge de la batterie (4) à ions Li, par exemple le courant de décharge et/ou la tension de décharge.

3. Dispositif de commande de batterie selon les revendications 1 ou 2, **caractérisé en ce qu'**un paramètre approprié correspond à la tension au repos (15) de la batterie au plomb.

4. Dispositif de commande de batterie selon l'une des revendications 1 à 3, **caractérisé en ce qu'**un paramètre approprié de la batterie au plomb correspond à une ligne caractéristique d'une tension au repos à basses valeurs de tension qui correspondent à une batterie virtuelle au plomb qui n'est pas une batterie réelle.

5. Dispositif de commande de batterie selon l'une des revendications 1 à 4, **caractérisé en ce qu'**un paramètre approprié de la batterie au plomb correspond à une rupture de tension en fonction de la charge.

6. Batterie configurée comme batterie à ions Li et dotée d'un dispositif (5) de commande de batterie selon l'une des revendications 1 à 5.

7. Batterie selon la revendication 6, **caractérisée en ce que** le dispositif (5) de commande de batterie est intégré dans un ensemble de gestion de la batterie.

8. Batterie selon les revendications 6 ou 7, **caractérisée en ce que** le dispositif de commande de batterie est disposé sur un câble de raccordement de la batterie.

9. Batterie selon l'une des revendications 6 à 8, **caractérisée en ce qu'**une fiche supplémentaire (7) et/ou les contacts auxiliaires d'un câble de raccordement de la batterie et/ou les contacts pilotes d'un câble de raccordement de la batterie servent de conducteurs (6) de raccordement au véhicule.

10. Véhicule configuré comme machine mobile de travail ou comme chariot de manutention entraîné électriquement par batterie et présentant une batterie (4) qui peut être insérée comme batterie de traction dans un compartiment (13) à batterie, le véhicule (1) présentant un dispositif d'état de charge de la batterie capable de déterminer l'état de charge d'une batterie au plomb à l'aide de lignes caractéristiques ou de champs caractéristiques d'au moins un paramètre, une batterie selon l'une des revendications 6 à 17 pouvant être utilisée comme batterie (4) et des possibilités appropriées de raccordement ou de réception étant prévues pour le moyen de raccordement (16).

11. Véhicule selon la revendication 10, **caractérisé en ce qu'**une batterie dotée d'un dispositif de commande de batterie selon la revendication 3 peut être insérée dans le véhicule et **en ce qu'**une ligne caractéristique d'une tension au repos à basses valeurs de tension correspondant à une batterie virtuelle non réelle est intégrée dans le dispositif d'état de charge de batterie du véhicule.

12. Véhicule selon les revendications 10 ou 11, **caractérisé en ce que** les moyens de liaison (16) sont configurés comme conducteurs de liaison (6) et **en ce que** des capteurs supplémentaires de tension saisissent les tension appliquées sur le conducteur de liaison (6) et peuvent les amener au dispositif d'état de charge de batterie du véhicule.

13. Système constitué d'au moins un véhicule (1) selon l'une des revendications 10 à 12, d'au moins une batterie au plomb et d'au moins d'une batterie (4) configurée comme batterie à ions Li selon l'une des revendications 6 à 9.
